# EUROPEAN PATENT APPLICATION

(11) **EP 4 086 955 A1**
(43) Date of publication of application: **09.11.2022**
(21) Application number: 20911018.8
(22) Date of filing: 06.05.2020
(51) Int. Cl.: H01L 25/00, H01L 23/488, H01L 21/50

(54) **SEMICONDUCTOR STRUCTURE HAVING STACKED UNITS AND MANUFACTURING METHOD THEREFOR, AND ELECTRONIC DEVICE**

(30) Priority: 31.12.2019 CN 201911424796
(71) Applicant: Rofs Microsystem (Tianjin) Co., Ltd, Tianjin 300462 (CN)
(72) Inventor: ZHANG, Lanyue, Tianjin 300462 (CN); PANG, Wei, Tianjin 300072 (CN); WEN, Pan, Tianjin 300462 (CN); ZHANG, Wei, Tianjin 300462 (CN); YANG, Qingrui, Tianjin 300072 (CN); ZHANG, Menglun, Tianjin 300072 (CN)
(74) Representative: Ström & Gulliksson AB
(86) International application number: PCT/CN2020/088723
(87) International publication number: WO 2021/135013

(57) **Abstract**

The present disclosure relates to a semiconductor structure having stacked units, including at least two units stacked in a thickness direction of the semiconductor structure; the at least two units are provided with at least one chip and include at least one unit pair; the unit pair includes an upper unit and a lower unit which are adjacent in the thickness direction of the semiconductor structure, the upper unit is above the lower unit, and both the upper unit and the lower unit include a base; the lower surface of the base of the upper unit is provided with a plurality of bump structures protruding downward, and each bump structure is covered with a bonding layer, and the bonding layer forms a bonding-bump structure together with the bump structure; the upper surface of the base of the lower unit is provided with conductive bumps protruding upward, and each bonding-bump structure and a corresponding conductive bump are opposite and aligned with each other, and are connected by bonding; and a first accommodating space is defined between the lower surface of the base of the upper unit and the upper surface of the base of the lower unit. The present disclosure further relates to a manufacturing method for a semiconductor structure having stacked units, and an electronic device having the structure.

## Description

### TECHNICAL FIELD

Embodiments of the present disclosure relates to the field of semiconductors, and in particular, to a semiconductor structure and a manufacturing method thereof, and an electronic apparatus with the semiconductor structure.

### BACKGROUND

With rapid development of the wireless communication technologies and increasingly extensive application of the miniaturized portable terminal apparatus, a demand for high-performance and small-size RF front-end modules and devices is increasing. In recent years, based on, for example, a Film Bulk Acoustic Resonator (FBAR), filters, diplexers and other filter devices have become more and more popular in the market. This is because on the one hand, they have excellent electrical properties such as low insertion loss, steep transition characteristics, high selectivity, high power capacity, strong electrostatic discharge (ESD) resistance, and on the other hand, they are small in volume and easy to be integrated.

However, it is required to further reduce a dimension of a filter device.

### SUMMARY

In order to further reduce a dimension of, for example, a filter device, a method of vertically stacking semiconductor devices has been provided in the related art, which requires wafer-level package bonding. The metal bonding is a common method that is simple and has good sealing property. However, the wet etching is required in the metal patterning and isotropy of a wet etching solution leads to serious lateral etching, so controllability of a pattern dimension is poor, resulting in poor bonding sealing property. In order to solve or alleviate the problem of poor bonding sealing property, a structure and method for bonding and aligning in the vertical stack packaging is provided in the present disclosure.

According to an aspect of embodiments of the present disclosure, a semiconductor structure with stacked units is provided, and includes at least two units stacked in a thickness direction of the semiconductor structure. The at least two units are provided with at least one chip and include at least one pair of units. The at least one pair of units include an upper unit and a lower unit arranged adjacent to each other in the thickness direction of the semiconductor structure. The upper unit is arranged above the lower unit. A lower surface of the substrate of the upper unit is provided with a plurality of protrusion structures protruding downwardly, and a bonding layer covers the plurality of protrusion structures in such a manner that the bonding layer and the plurality of protrusion structures form bonding-protrusion structures. An upper surface of the substrate of the lower unit is provided with conductive protrusions protruding upwardly, each of the bonding-protrusion structures is oppositely aligned and connected with one of the conductive protrusions through bonding, and the lower surface of the substrate of the upper unit and the upper surface of the substrate of the lower unit form a first accommodation space therebetween.

An embodiment of the present disclosure further relates to a method of manufacturing a semiconductor structure with stacked units. The method includes: providing a first unit, the first unit including a first substrate and a plurality of first holes passing through the first substrate; thinning the first substrate from a lower surface of the first substrate to form a first lower surface to expose the plurality of first holes, a first protrusion structure being formed around each of the plurality of first holes and protruding from the first lower surface; covering a bonding layer on the first protrusion structure to form a plurality of first bonding-protrusion structures; providing a second unit including a second substrate, the second substrate being provided with a plurality of second bonding protrusions at an upper surface thereof; and bonding the plurality of first bonding-protrusion structures with the plurality of second bonding protrusions in one-to-one correspondence to form a first accommodation space between the first substrate and the second substrate.

An embodiment of the present disclosure further relates to an electronic apparatus including the above semiconductor structure.

### BRIEF DESCRIPTION OF DRAWINGS

The following description and drawings can facilitate to understand these and other features and advantages in various embodiments disclosed in the present disclosure. The same reference signs in the drawings always indicate the same components.
FIG. 1 is a schematic sectional view of a semiconductor structure with stacked units according to an exemplary embodiment of the present disclosure, in which the semiconductor structure has only three layers of substrates.
FIG. 1A is a schematic sectional view further illustratively showing a bonding-protrusion structure provided at a lower side of a substrate.
FIGS. 2A to 2G are schematic diagrams illustratively showing a manufacturing process of the semiconductor structure in FIG. 1.
FIG. 3 is a schematic sectional view of a semiconductor structure with stacked units according to an exemplary embodiment of the present disclosure, in which the semiconductor structure has five layers of substrates.
FIGS. 4A to 4C are schematic sectional views showing a protrusion structure of a semiconductor structure according to an exemplary embodiment of the present disclosure, respectively.
FIG. 5 is a schematic sectional view of a semiconductor structure with stacked units according to an exemplary embodiment of the present disclosure, in which the semiconductor structure has only three layers of substrates and conductive through holes penetrate through the first substrate.
FIG. 6 is a schematic sectional view of a semiconductor structure with stacked units in the related art.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

In the present disclosure, the semiconductor structure is illustrated by taking an acoustic wave filter as an example. The acoustic wave filter can be electrically connected in a vertical direction in a multi-substrate manner, which can reduce an area of a device, such as a filter, a duplexer, and a quadplexer, by more than 30%.

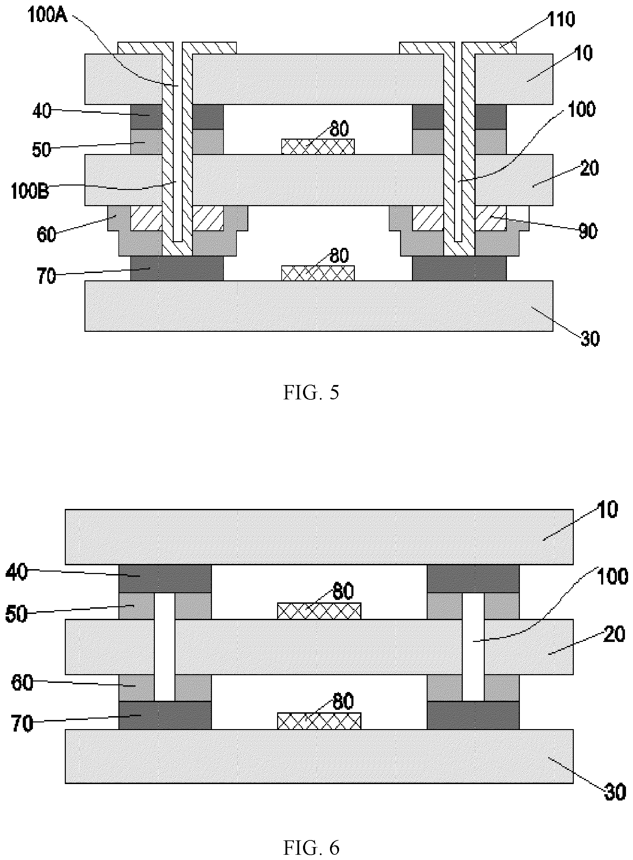

In an embodiment of the present disclosure, electrical input and output are provided on an upper surface of a protective layer or a first substrate 10 (as described later), which is a topmost layer of the semiconductor structure. A lower surface of the corresponding semiconductor structure does not need to be provided with through holes functioning as electrical leads. For example, in FIG. 5, a substrate 30 located at a lower side of the semiconductor structure is not provided with conductive through holes, but the conductive through holes and conductive pads 110 are provided on the upper surface of the protective layer 10.

Metals that are bonded to each other between adjacent substrates have two functions, one is to ensure electrical connection and the other is to ensure sealing property. A metal bonding structure configured to perform electrical connection is merely shown in the figures of the present disclosure.

In an embodiment of the present disclosure, the protective layer or the first substrate 10 is used as a topmost substrate of the semiconductor structure. For example, as shown in the figure, in the semiconductor structure, upward surfaces of the substrates each are an upper surface, and downward surfaces of the substrate each are a lower surface.

FIG. 6 is a schematic sectional view of a semiconductor structure with stacked units in the related art. Reference numbers are described as follows.

10: First Substrate; 20: Second Substrate; 30: Third Substrate; 40: Bonding Metal; 50: Bonding Metal; 60: Bonding Metal; 70: Bonding Metal; 80: Chip or Semiconductor Device; 100: Conductive Through Hole.

In the structure shown in FIG. 6, when the bonding metal 60 is patterned, overetching or metal shedding may occur, resulting in poor bonding sealing performance.

In addition, if the bonding metal 60 is etched by a dry method, the cost is very high. If a metal liftoff process is used, the metal cannot be lifted off completely due to a relatively large thickness of the metal, for example, a thickness of the bonding metal 60 is in a range of 3 to 6 microns, which is a difficult process. If the bonding metal 60 is etched by wet etching, it is difficult to control metal patterning profile, resulting in overetching and shedding.

According to the present disclosure, the structure is optimized and a protrusion structure is provided during bonding and packaging, so that the above problems can be solved and the sealing effect can be improved.

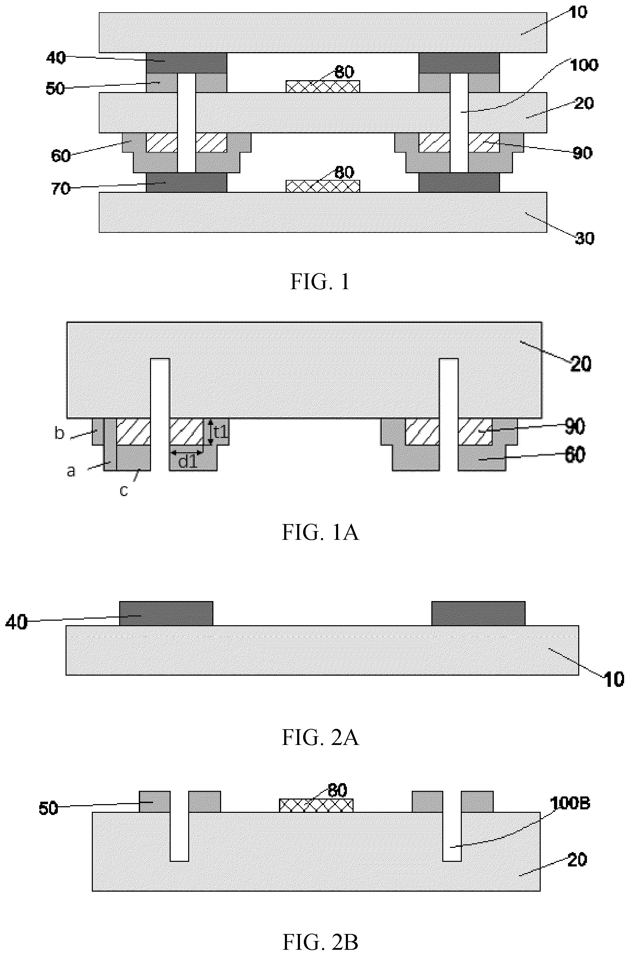

FIG. 1 is a schematic sectional view of a semiconductor structure with stacked units according to an exemplary embodiment of the present disclosure, in which the semiconductor structure has only three layers of substrates. In FIG. 1, components indicated by reference signs are described as follows.

10: First substrate, which may be used as a protective layer or protective sealing layer, and may be made of a material such as monocrystalline silicon, gallium arsenide, sapphire, and quartz.

20: Second substrate, which may be made of a material such as monocrystalline silicon, gallium arsenide, sapphire, and quartz.

30: Third substrate, which may be made of a material such as monocrystalline silicon, gallium arsenide, sapphire, and quartz.

40: Bonding metal, which is provided on the first substrate, and may be made of a material such as molybdenum, ruthenium, gold, aluminum, magnesium, tungsten, copper, titanium, iridium, osmium, chromium, or composites or alloys thereof.

50: Bonding metal, which is provided on the second substrate, and may be made of a material such as molybdenum, ruthenium, gold, aluminum, magnesium, tungsten, copper, titanium, iridium, osmium, chromium, or composites or alloys thereof.

60: Bonding metal, which is provided on a protrusion structure of the second substrate, and may be made of a material such as molybdenum, ruthenium, gold, aluminum, magnesium, tungsten, copper, titanium, iridium, osmium, chromium, or composites or alloys thereof.

70: Bonding metal, which is provided on the third substrate, and may be made of a material such as molybdenum, ruthenium, gold, aluminum, magnesium, tungsten, copper, titanium, iridium, osmium, chromium, or composites or alloys thereof.

80: Chip or semiconductor device, which for example is an electrical connection structure of an acoustic wave resonator or a plurality of acoustic wave resonators. The acoustic wave resonator includes, but is not limited to, an acoustic mirror, which may be a cavity, or may employ a Bragg reflection layer or other equivalent forms; a top electrode (an electrode pin), which can be made of a material such as molybdenum, ruthenium, gold, aluminum, magnesium, tungsten, copper, titanium, iridium, osmium, chromium, or composites or alloys thereof; a piezoelectric film layer, which may be made of a material such as aluminum nitride, zinc oxide, and PZT and contain the above materials doped with a certain atomic ratio of rare earth element; a top electrode (an electrode pin), which may be made of a material such as molybdenum, ruthenium, gold, aluminum, magnesium, tungsten, copper, titanium, iridium, osmium, chromium, or composites or alloys thereof.

90: Protrusion structure, which is provided on a lower surface of the second substrate in the figures and is integrally formed with the second substrate.

100: Through hole structure, in which conductive materials are provided, and which may be made of a material such as molybdenum, ruthenium, gold, aluminum, magnesium, tungsten, copper, titanium, iridium, osmium, chromium, or composites or alloys thereof. As can be understood by those skilled in the art, conductive through holes are formed by filling conductive materials in the through hole structure 100.

In the present disclosure, in the semiconductor structure as shown in the figures, upward surfaces of the substrates each are an upper surface, and downward surfaces of the substrate each are a lower surface.

In FIG. 1, the conductive through holes 100 pass through the first substrate 10, the bonding metal 40, the bonding metal 50, the second substrate 20, the protrusion structure 90, and the bonding metal 60.

As shown in FIG. 1, a protective layer bonding structure (i.e., the bonding metal 40) is provided on a lower surface of the first substrate 10 below the through holes 100. An upper bonding structure of the second substrate (i.e., the bonding metal 50) is provided on an upper surface of the second substrate 20, and an upper bonding structure of the second substrate (i.e., the bonding metal 60) is provided on a lower surface of the second substrate 20. An upper bonding structure of the third substrate (i.e., the bonding metal 70) is provided on an upper surface of the third substrate 30. When the first substrate 10, the second substrate 20 and the third substrate 30 are stacked, the bonding structures are bonded to each other. As shown in FIG. 1, the conductive through holes 100 pass through a respective bonding structure of the bonding structures to be electrically connected to a bonding structure on a respective substrate (a substrate where a unit to be electrically connected with the conductive through holes is located). In other words, as can be understood by those skilled in the art, the bonding between adjacent substrates or adjacent layers is obtained through the adjacent bonding structures. In addition, connecting through holes provided between the adjacent layers may be formed by the bonding structures.

As shown in FIG. 1, an upper end of each of the conductive through holes is opened or located on an upper surface of the first substrate 10. As shown in FIG. 1, conductive pads 110 are provided and each are electrically connected to an upper end of one of the conductive through holes on the upper surface of the first substrate 10.

In FIG. 1, the lower surface of the second substrate 20 is provided with the protrusion structure 90 protruding downward. The through hole 100 passes through the protrusion structure 90, and the bonding metal 60 covers an outer side of the protrusion structure 90 around the through hole. In a further embodiment, as shown in FIG. 1, the bonding metal 60 covers the protrusion structure 90 and a part of the lower surface of the second substrate on both sides of the protrusion structure in a lateral direction, also as shown in the FIG. 1A. The bonding metal 60 has a width in the lateral direction, and the width is 1 µm or more larger than a width of the protrusion structure 90, to ensure that a bonding dimension is defined by the protrusion structure 90, which reduces alignment accuracy of photoetching alignment when the bonding metal 60 is formed. In addition, a height of the protrusion structure 90 increases a sacrificial length of the bonding metal 60 during the lateral etching, which finally ensures that a top or end face of the protrusion structure 90 is covered by the bonding metal 60. A bonding-protrusion structure formed by combination of the protrusion structure 90 and the bonding metal 60 enables a dimension of the bonding metal to be determined by the protrusion structure 90 with higher dimension controlling accuracy, which reduces requirement for the alignment accuracy and solves a problem of poor bonding sealing performance of the bonding metal 60. In the present disclosure, the protrusion structure 90 is provided to at least maintain a good profile of the bonding metal 60 on the substrate 20 and easily form a self-aligned structure with the substrate 30.

FIG. 1A is a schematic sectional view further showing the bonding-protrusion structure provided on a lower side of the substrate. As shown in FIG. 1A, the bonding layer 60 has regions a, b and c. When the bonding layer or bonding metal 60 is wet etched, 50% of overetching is generally provided to the wet etching due to an isotropic principle of the wet etching and complete etching of the un-patterned metal. As shown in Figure 1A, a part of the metal in the region b is prone to be overetched, and another part of the metal in the region a cannot be completely etched due to existence of the protrusion structure 90 even if the etching time is increased by 50%. Accordingly, the patterning structure of the metal in the region c is maintained, which provides good foundation for following bonding and self-alignment and guarantees sealing performance of a product.

As shown in FIG. 1A, in an alternative embodiment, a height t1 may be in a range of 2 µm to 10 µm, and a width d1 may be in a range of 20 µm to 300 µm. Specifically, the width is 20 µm, 100 µm, or 300 µm, and the height is 2 µm, 5 µm, or 10 µm.

In an embodiment of the present disclosure, the protrusion structure 90 is made of a material same as that of the substrate 20, which is obtained by thinning the substrate 20. The protrusion structure 90 is made of a material different from that of the substrate 20.

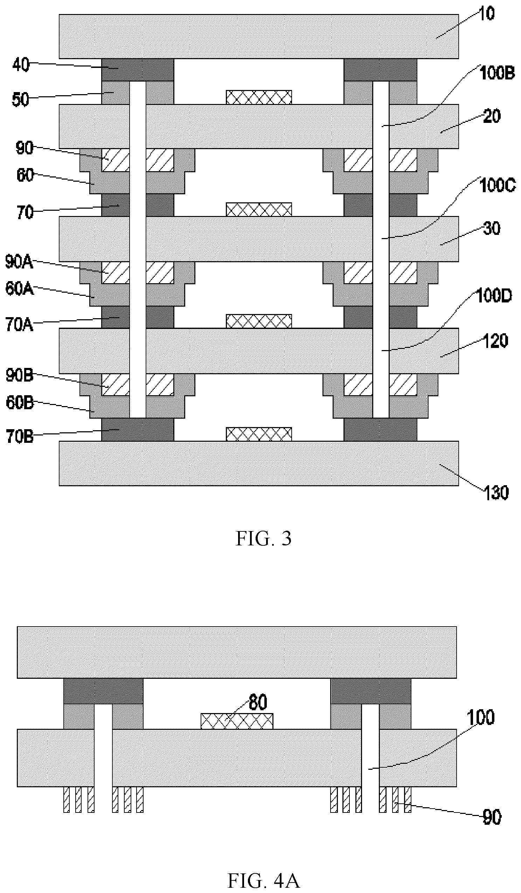

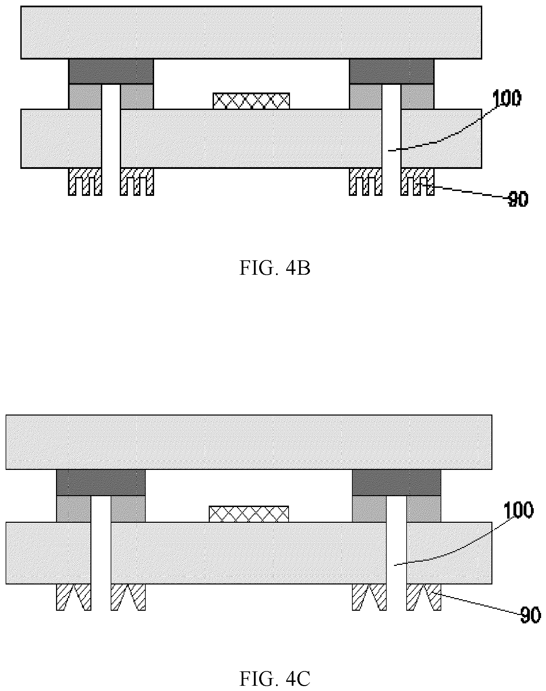

FIGS. 4A to 4C are schematic sectional views showing a protrusion structure of a semiconductor structure according to an exemplary embodiment of the present disclosure, respectively. In FIG. 4A, the protrusion structure 90 is a comb structure. In FIG. 4B, the protrusion structure 90 is a semi-comb structure. In FIG. 4C, the protrusion structure 90 is a concave wedge structure. In FIGS. 4A to 4C, the through holes 100 pass through the protrusion structures, and each of the protrusion structures is arranged around one of the through holes 100. FIGS. 4A to 4C are examples in which an end face of the protrusion structure is configured to be a concave-convex structure. A bonding end face of the protrusion structure 90 is configured to be a concave-protrusion structure, which facilitates preventing the bonding metal 60 from shedding and improving the sealing property between the bonding metal 60 and the bonding metal 70.

Referring to FIGS. 2A to 2F, a method of forming the semiconductor structure with a plurality of stacked units shown in FIG. 1 by a vertical stacking process is illustrated.

As shown in FIG. 2A, a first substrate 10 is provided, and the bonding metal 40 is provided on the first substrate.

As shown in FIG. 2B, the second substrate 20 is provided. The bonding metal 50 is provided on an upper surface of the second substrate. The second substrate 20 is further provided with second through holes 100B, which pass through the bonding metal 50 and partially enter the second substrate 20. A semiconductor device 80 is provided on the second substrate.

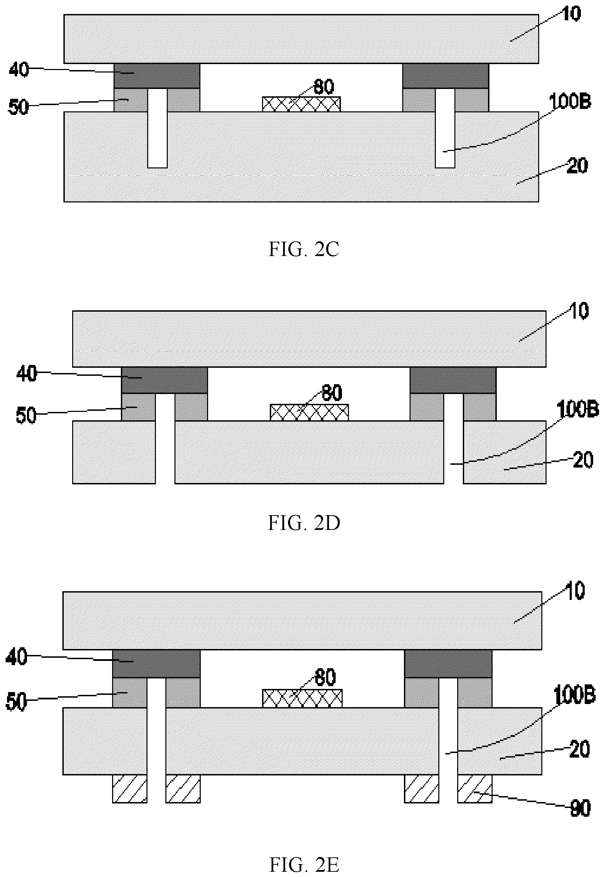

As shown in FIG. 2C, the first substrate 10 is arranged opposite to the second substrate 20, and the bonding metal 40 and the corresponding bonding metal 50 are bonded to each other.

As shown in FIG. 2D, the second substrate is thinned from the lower surface of the second substrate to expose the second through holes 100B.

After that, as shown in FIG. 2E, the protrusion structure 90 is formed on the lower surface of the second substrate 20 by etching and other processes, and the protrusion structure 90 protrudes from the lower surface of the second substrate.

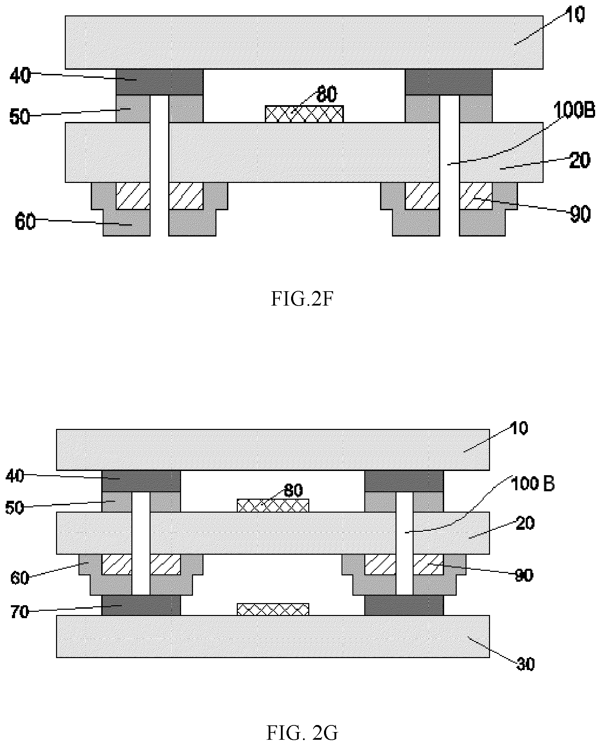

As shown in FIG. 2F, the bonding metal 60 covers the protrusion structure 90, and the second through holes 100B pass through the bonding metal 60.

As shown in FIG. 2G, the third substrate 30 is provided, and the bonding metal 70 and a semiconductor device 80 are provided on an upper surface of the third substrate. The third substrate 30 is then arranged opposite to the second substrate 20, and the bonding metal 70 and the corresponding bonding metal 60 are bonded to each other.

In the present disclosure, a wall thickness of a conductive metal pillar in each of the through holes is gradually decreased from top to bottom.

In the present disclosure, the conductive through holes are filled in one time to form an integrally molded conductive pillar. The integrally molding of the conductive pillar means that the conductive pillar is integrally molded based on a single filling of conductive materials, instead of filling two conductive through holes respectively and then performing a bonding operation to communicate the two conductive through holes with each other. Because the conductive pillar is integrally molded, the problems such as holes, virtual connections and contamination defects are easy to be formed at two metal-filling contacts caused by the bonding operation do not exist at the conductive pillars in the present disclosure.

FIG. 3 is a schematic sectional view of a semiconductor structure with stacked units according to an exemplary embodiment of the present disclosure, in which the semiconductor structure has five layers of substrates. A specific number of the layers herein is only exemplary, and the semiconductor structure may have other number of layers.

In order to laminate or stack a fourth substrate on a lower surface of the third substrate, although no specific steps are shown, it can be understood by those skilled in the art to achieve following embodiments based on the above description.

In the step of "providing the third substrate", the third substrate 30 has a plurality of third holes 100C passing through a corresponding bonding metal 70 and partially entering the third substrate 30.

In the step of "bonding the bonding metal 70 and the corresponding bonding metal 60", each of the second through holes 100B is aligned with and communicates with oen of the third through holes 100C.

Similarly to forming the protrusion structure 90 and the bonding metal 60 on the lower surface of the second substrate 20, in which the first bonding-protrusion structure is formed, the third substrate is thinned from the lower surface of the third substrate 30 to form a new lower surface to expose the third through holes 100C. Another protrusion structure 90A is formed around the third through holes 100C, and protrudes from the new lower surface.

After that, the bonding metal 60A covers the another protrusion structure 90A, in which a second bonding-protrusion structure is formed.

A fourth substrate 120 is then provided. At least one of the fourth substrate 120 and the third substrate 30 is provided with a chip, and an upper surface of the fourth substrate 120 is provided with a plurality of bonding metals 70A.

Each of the bonding metals 60A is bonded to one of the plurality of bonding metals 70A on the fourth substrate 120 to form an accommodation space between the third substrate 30 and the fourth substrate 120.

In this way, more layers are stacked. In FIG. 3, a fifth substrate 130 is further stacked. The fourth substrate 120 is provided with fourth through holes 100D, and the protrusion structure 90B is covered by the bonding metal 60B, in which a third bonding-protrusion structure is formed. A bonding metal 70B are provided on the second substrate 130, and the bonding metal 70B is bonded to the corresponding bonding metal 60B.

In FIG. 3, the second through holes 100B, the third through holes 100C and the fourth through holes 100D are aligned and communicated with each other.

In the above embodiments of the present disclosure shown in FIGS. 1 to 4C, the first substrate 10 is used as the protective layer, and no through hole is provided therethrough. However, the present disclosure is not limited to this. The first substrate 10 may be provided with a first through hole. As shown in FIG. 5, the first substrate 10 is provided with the first through holes 100A, which are aligned and communicated with the second through holes 100B in one-to-one correspondence to form the conductive through holes 100. The upper surface of the first substrate 10 is further provided with conductive pads 110, which may be made of a material such as molybdenum, ruthenium, gold, aluminum, magnesium, tungsten, copper, titanium, iridium, osmium, chromium, or composites or alloys thereof.

Although not shown, the lower surface of the first substrate 10 may further be provided with a bonding-protrusion structure.

After the first through hole are aligned and communicated with the second through hole, effective electrical connection is formed in the first through hole 100A and the second through hole 100B through an electroplating process, i.e., the conductive through holes 100 are formed. This one-time filling can effectively solve or alleviate problems of poor bonding effect in a second time and poor sealing performance caused by separate filling of through holes. Meanwhile, it provides better electrical conduction performance and process steps can be saved. Finally, the conductive pads 110 are formed to be electrically connected to the conductive through holes 100 in one-to-one correspondence.

In the present disclosure, corresponding conductive through holes in different layers may not be axially communicated with each other, but may be staggered in a radial direction. For example, although not shown, in two adjacent layers stacked to each other in a thickness direction, the conductive through holes electrically connected to an upper layer of the two adjacent layers each are located at an inner side of one of the conductive through holes electrically connected to a lower layer of the two adjacent layers in the radial direction or lateral direction.

In view of the above, the present disclosure provides following technical solutions.
1. A semiconductor structure with stacked units includes at least two units stacked in a thickness direction of the semiconductor structure, the at least two units are provided with at least one chip and include at least one pair of units, the at least one pair of units include an upper unit and a lower unit arranged adjacent to each other in the thickness direction of the semiconductor structure, and the upper unit is arranged above the lower unit, wherein
   the upper unit and the lower unit each include a substrate;
   a lower surface of the substrate of the upper unit is provided with a plurality of protrusion structures protruding downwardly, a bonding layer covers the plurality of protrusion structures in such a manner that the bonding layer and the plurality of protrusion structures form bonding-protrusion structures; and
   an upper surface of the substrate of the lower unit is provided with conductive protrusions protruding upwardly, each of the bonding-protrusion structures is oppositely aligned and connected with one of the conductive protrusions through bonding, and the lower surface of the substrate of the upper unit and the upper surface of the substrate of the lower unit form a first accommodation space therebetween.
2. The semiconductor structure according to 1, wherein
   the semiconductor structure further includes conductive through holes that pass through at least one substrate of the substrates to form electrical connection with underside of the at least one substrate, and each of the conductive through holes or an axis of each of the conductive through holes passes through one of the bonding-protrusion structures.
3. The semiconductor structure according to 2, wherein
   the conductive through holes include conductive through holes, which pass through the substrate of the upper unit and are electrically connected to the bonding-protrusion structures in one-to-one correspondence.
4. The semiconductor structure according to 2, wherein
   the at least one pair of units include at least two pairs of units, and the at least two pairs of units include a first unit, a second unit, and a third unit that are sequentially stacked from top to bottom in the thickness direction of the semiconductor structure, wherein the first unit and the second unit form a first pair of units, and the second unit and the third unit form a second pair of units.
5. The semiconductor structure according to 4, wherein
   the conductive through holes include conductive through holes, which pass through at least one substrate of the at least two pairs of units and are electrically connected to the bonding-protrusion structures in one-to-one correspondence.
6. The semiconductor structure according to 5, wherein
   each of the conductive through hole is provided with a conductive pillar therein, and the conductive pillar is an integrally molded conductive pillar.
7. The semiconductor structure according to 6, wherein
   the integrally molded conductive pillar is a conductive pillar with a wall thickness gradually decreasing from top to bottom.
8. The semiconductor structure according to any one of 2 to 7, wherein
   two uppermost units of the at least two units of the semiconductor structure form an uppermost pair of units, a substrate of an unit of an uppermost layer of the semiconductor structure forms a protective layer, and the protective layer has an upper surface and a lower surface; and
   the conductive through holes include conductive through holes that extend from the upper surface of the protective layer through the protective layer and extend downwardly through a corresponding one of the substrates in a thickness direction of the protective layer, in such a manner that the conductive through holes are electrically connected to the bonding-protrusion structures of a corresponding one of the at least two units.
9. The semiconductor structure according to 8, wherein
   the conductive through holes include conductive through holes that are electrically connected to the bonding-protrusion structures of a corresponding one of the at least two units located below the protective layer.
10. The semiconductor structure according to 8, wherein
   the conductive through holes include conductive through holes that are electrically connected to the bonding-protrusion structures of at least two corresponding units below the protective layer.
11. The semiconductor structure according to 10, wherein
   the conductive through holes include conductive through holes that are electrically connected to bonding-protrusion structures of all of the units of the at least two units provided with the bonding-protrusion structures.
12. The semiconductor structure according to 2, wherein
   two uppermost units of the semiconductor structure form an uppermost pair of units, a substrate of an unit of an uppermost layer of the semiconductor structure forms a protective layer, and the protective layer has an upper surface and a lower surface; and
   the conductive through holes include conductive through holes that extend downwardly from the upper surface of the protective layer through the protective layer in a thickness direction of the protective layer to be electrically connected to a lower unit of the uppermost pair of units.
13. The semiconductor structure according to 2, wherein
   in a radial direction, the conductive through holes electrically connected with the upper unit of the at least one pair of units each are located at an inner side of one of the conductive through holes electrically connected with the lower unit of the at least one pair of units.
14. The semiconductor structure according to 8, wherein
   the semiconductor structure further includes conductive pads, and the conductive pads are located on the upper surface of the protective layer and electrically connected with the conductive through holes.
15. The semiconductor structure according to any one of 1 to 14, wherein
   the plurality of protrusion structures is integrally formed with one of the substrate where the plurality of protrusion structures is located.
16. The semiconductor structure according to 15, wherein
   the bonding layer covers the plurality of protrusion structures, and covers a part of the lower surface of the substrate on both sides of the plurality of protrusion structures in the lateral direction.
17. The semiconductor structure according to 15, wherein
   the conductive through holes include conductive through holes passing through the bonding-protrusion structures in one-to-one correspondence.
18. The semiconductor structure according to 17, wherein
   an end face of each of the plurality of protrusion structures is provided with a concave-convex shape arranged around one of the conductive through holes.
19. The semiconductor structure according to 18, wherein
   the concave-convex shape includes a comb structure or a concave wedge structure.
20. The semiconductor structure according to any one of 2 to 14, wherein
   the plurality of protruding structure has a protruding height t1 in a range of 2 µm to 10 µm; and/or
   the plurality of protrusion structure each forms an annular structure around one of the through holes, and the annular structure has a width d1 in a range of 20 µm to 300 µm.
21. The semiconductor structure according to 1, wherein
   the semiconductor structure is a film bulk acoustic wave resonator, a film bulk acoustic wave filter, a duplexer, or a quadplexer.
22. A method of manufacturing a semiconductor structure with stacked units includes:
   providing a first unit, the first unit including a first substrate and a plurality of first holes passing through the first substrate;
   thinning the first substrate from a lower surface of the first substrate to form a first lower surface to expose the plurality of first holes, a first protrusion structure being formed around each of the plurality of first holes and protruding from the first lower surface;
   covering a bonding layer on the first protrusion structure to form a plurality of first bonding-protrusion structures;
   providing a second unit including a second substrate, the second substrate being provided with a plurality of second bonding protrusions at an upper surface thereof; and
   bonding the plurality of first bonding-protrusion structures with the plurality of second bonding protrusions in one-to-one correspondence to form a first accommodation space between the first substrate and the second substrate.
23. The method according to 22, wherein
   in the step of "providing the second unit", the second unit has a plurality of second holes, and the plurality of second holes passes through the plurality of second bonding protrusions in one-to-one correspondence and partially enters the second substrate;
   in the step of "bonding the plurality of first bonding-protrusion structures with the plurality of second bonding protrusions in one-to-one correspondence", each of the plurality of first holes is aligned and communicated with one of the plurality of second holes; and
   the method further includes:
      thinning the second substrate from a lower surface of the second substrate to form a second lower surface to expose the plurality of second holes, a second protrusion structure being formed around each of the plurality of second holes and protruding from the second lower surface;
      covering a bonding layer on the second protrusion structure to form second bonding-protrusion structures;
      providing a third unit including a third substrate, the third substrate being provided with a plurality of third bonding protrusions on an upper surface thereof; and
      bonding the second bonding-protrusion structures with the plurality of third bonding protrusions in one-to-one correspondence to form a second accommodation space between the second substrate and the third substrate.
24. The method according to 22 or 23, wherein
   in the step of "providing the first unit", the first unit is provided with a plurality of first bonding protrusions on an upper surface thereof; and
   the method further includes: providing a forth unit including a forth substrate, the forth substrate being provided with a plurality of forth bonding protrusions on a lower surface thereof; and bonding the plurality of first bonding-protrusion structures with the plurality of forth bonding protrusions in one-to-one correspondence to form a third accommodation space between the first substrate and the forth substrate.
25. The method according to 22 or 23 further includes:
   forming the plurality of first holes into conductive through holes, each of the conductive through holes being electrically connected with one of the bonding-protrusion structures.
26. The method according to 24, wherein
   in the step of "providing the forth unit", the forth unit includes a plurality of forth holes, and the plurality of forth holes passes through the plurality of forth bonding protrusions in one-to-one correspondence and partially enters the forth substrate;
   in the step of "bonding the plurality of first bonding-protrusion structures with the plurality of forth bonding protrusions in one-to-one correspondence", the plurality of first holes each is aligned and communicated with one of the plurality of forth holes; and
   the method further includes:
      thinning the fourth substrate from an upper surface of the fourth substrate to form a new upper surface to expose the plurality of fourth holes;
      filling a conductive metal in the plurality of fourth holes and corresponding holes aligned and communicated with the plurality of fourth holes to form conductive through holes; and
      forming conductive pads on the upper surface of the fourth substrate, each of the conductive pads being electrically connected to one of the conductive through holes.
27. The method according to any one of 22 to 26, wherein
   in the step of forming the protrusion structures, each of the protrusion structure is formed by etching one of the substrate.
28. An electronic apparatus includes the semiconductor structure according to any one of 1 to 21 or a semiconductor structure manufactured by the method according to any one of 22 to 27.

In the present disclosure, the semiconductor structure may be a film bulk acoustic wave resonator, a film bulk acoustic wave filter, a duplexer, or a quadplexer. As can be understood, the semiconductor structure may be other structures based on different chips of units. In the present disclosure, the chip may include a semiconductor device, such as a microelectromechanical device, and an active or passive semiconductor device.

The electronic apparatus herein includes, but is not limited to, an intermediate product such as an RF front end, a filtering and amplifying module; and a terminal product such as a mobile phone, WIFI and a drone.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A semiconductor structure with stacked units, comprising:
at least two units stacked in a thickness direction of the semiconductor structure, the at least two units being provided with at least one chip and comprising at least one pair of units, the at least one pair of units comprising an upper unit and a lower unit arranged adjacent to each other in the thickness direction of the semiconductor structure, and the upper unit being arranged above the lower unit,
wherein the upper unit and the lower unit each comprise a substrate;
wherein a lower surface of the substrate of the upper unit is provided with a plurality of protrusion structures protruding downwardly, a bonding layer covers the plurality of protrusion structures in such a manner that the bonding layer and the plurality of protrusion structures form bonding-protrusion structures; and
wherein an upper surface of the substrate of the lower unit is provided with conductive protrusions protruding upwardly, each of the bonding-protrusion structures is oppositely aligned and connected with one of the conductive protrusions through bonding, and the lower surface of the substrate of the upper unit and the upper surface of the substrate of the lower unit form a first accommodation space therebetween.

2. The semiconductor structure according to claim 1, further comprising:
conductive through holes passing through at least one substrate of the substrates to form electrical connection with underside of the at least one substrate, and each of the conductive through holes or an axis of each of the conductive through holes passing through one of the bonding-protrusion structures.

3. The semiconductor structure according to claim 2, wherein the conductive through holes comprise conductive through holes, which pass through the substrate of the upper unit and are electrically connected to the bonding-protrusion structures in one-to-one correspondence.

4. The semiconductor structure according to claim 2, wherein the at least one pair of units comprise at least two pairs of units, and the at least two pairs of units comprise a first unit, a second unit, and a third unit that are sequentially stacked from top to bottom in the thickness direction of the semiconductor structure; and
the first unit and the second unit form a first pair of units, and the second unit and the third unit form a second pair of units.

5. The semiconductor structure according to claim 4, wherein the conductive through holes comprise conductive through holes, which pass through at least one substrate of the at least two pairs of units and are electrically connected to the bonding-protrusion structures in one-to-one correspondence.

6. The semiconductor structure according to claim 5, wherein each of the conductive through hole is provided with a conductive pillar therein, and the conductive pillar is an integrally molded conductive pillar.

7. The semiconductor structure according to claim 6, wherein the integrally molded conductive pillar is a conductive pillar with a wall thickness gradually decreasing from top to bottom.

8. The semiconductor structure according to any one of claims 2 to 7, wherein two uppermost units of the at least two units of the semiconductor structure form an uppermost pair of units, a substrate of an unit of an uppermost layer of the semiconductor structure forms a protective layer, and the protective layer has an upper surface and a lower surface; and
the conductive through holes comprise conductive through holes that extend from the upper surface of the protective layer through the protective layer and extend downwardly through a corresponding one of the substrates in a thickness direction of the protective layer, in such a manner that the conductive through holes are electrically connected to the bonding-protrusion structures of a corresponding one of the at least two units.

9. The semiconductor structure according to claim 8, wherein the conductive through holes comprise conductive through holes that are electrically connected to the bonding-protrusion structures of a corresponding one of the at least two units located below the protective layer.

10. The semiconductor structure according to claim 8, wherein the conductive through holes comprise conductive through holes that are electrically connected to the bonding-protrusion structures of at least two corresponding units below the protective layer.

11. The semiconductor structure according to claim 10, wherein the conductive through holes comprise conductive through holes that are electrically connected to bonding-protrusion structures of all of the units of the at least two units provided with the bonding-protrusion structures.

12. The semiconductor structure according to claim 2, wherein two uppermost units of the semiconductor structure form an uppermost pair of units, a substrate of an unit of an uppermost layer of the semiconductor structure forms a protective layer, and the protective layer has an upper surface and a lower surface; and
the conductive through holes comprise conductive through holes that extend downwardly from the upper surface of the protective layer through the protective layer in a thickness direction of the protective layer to be electrically connected to a lower unit of the uppermost pair of units.

13. The semiconductor structure according to claim 2, wherein in a radial direction, the conductive through holes electrically connected with the upper unit of the at least one pair of units each are located at an inner side of one of the conductive through holes electrically connected with the lower unit of the at least one pair of units.

14. The semiconductor structure according to claim 8, further comprising:
conductive pads provided on the upper surface of the protective layer and electrically connected with the conductive through holes.

15. The semiconductor structure according to any one of claims 1 to 14, wherein the plurality of protrusion structures is integrally formed with one of the substrate where the plurality of protrusion structures is located.

16. The semiconductor structure according to claim 15, wherein the bonding layer covers the plurality of protrusion structures, and covers a part of the lower surface of the substrate on both sides of the plurality of protrusion structures in the lateral direction.

17. The semiconductor structure according to claim 15, wherein the conductive through holes comprise conductive through holes passing through the bonding-protrusion structures in one-to-one correspondence.

18. The semiconductor structure according to claim 17, wherein an end face of each of the plurality of protrusion structures is provided with a concave-convex shape arranged around one of the conductive through holes.

19. The semiconductor structure according to claim 18, wherein the concave-convex shape comprises a comb structure or a concave wedge structure.

20. The semiconductor structure according to any one of claims 2 to 14, wherein the plurality of protruding structure has a protruding height t1 in a range of 2 µm to 10 µm; and/or
the plurality of protrusion structure each forms an annular structure around one of the through holes, and the annular structure has a width d1 in a range of 20 µm to 300 µm.

21. The semiconductor structure according to claim 1, wherein the semiconductor structure is a film bulk acoustic wave resonator, a film bulk acoustic wave filter, a duplexer, or a quadplexer.

22. A method of manufacturing a semiconductor structure with stacked units, comprising:
providing a first unit, the first unit including a first substrate and a plurality of first holes passing through the first substrate;
thinning the first substrate from a lower surface of the first substrate to form a first lower surface to expose the plurality of first holes, a first protrusion structure being formed around each of the plurality of first holes and protruding from the first lower surface;
covering a bonding layer on the first protrusion structure to form a plurality of first bonding-protrusion structures;
providing a second unit comprising a second substrate, the second substrate being provided with a plurality of second bonding protrusions at an upper surface thereof; and
bonding the plurality of first bonding-protrusion structures with the plurality of second bonding protrusions in one-to-one correspondence to form a first accommodation space between the first substrate and the second substrate.

23. The method according to claim 22, wherein in the providing the second unit, the second unit has a plurality of second holes, and the plurality of second holes passes through the plurality of second bonding protrusions in one-to-one correspondence and partially enters the second substrate;
in the bonding the plurality of first bonding-protrusion structures with the plurality of second bonding protrusions in one-to-one correspondence, each of the plurality of first holes is aligned and communicated with one of the plurality of second holes; and
the method further comprises:
thinning the second substrate from a lower surface of the second substrate to form a second lower surface to expose the plurality of second holes, a second protrusion structure being formed around each of the plurality of second holes and protruding from the second lower surface;
covering a bonding layer on the second protrusion structure to form second bonding-protrusion structures;
providing a third unit comprising a third substrate, the third substrate being provided with a plurality of third bonding protrusions on an upper surface thereof; and
bonding the second bonding-protrusion structures with the plurality of third bonding protrusions in one-to-one correspondence to form a second accommodation space between the second substrate and the third substrate.

24. The method according to claim 22 or 23, wherein in the providing the first unit, the first unit is provided with a plurality of first bonding protrusions on an upper surface thereof; and
the method further comprises:
providing a forth unit comprising a forth substrate, the forth substrate being provided with a plurality of forth bonding protrusions on a lower surface thereof; and
bonding the plurality of first bonding-protrusion structures with the plurality of forth bonding protrusions in one-to-one correspondence to form a third accommodation space between the first substrate and the forth substrate.

25. The method according to claim 22 or 23, further comprising:
forming the plurality of first holes into conductive through holes, each of the conductive through holes being electrically connected with one of the bonding-protrusion structures.

26. The method according to claim 24, wherein in the providing the forth unit, the forth unit comprises a plurality of forth holes, and the plurality of forth holes passes through the plurality of forth bonding protrusions in one-to-one correspondence and partially enters the forth substrate;
in the bonding the plurality of first bonding-protrusion structures with the plurality of forth bonding protrusions in one-to-one correspondence, the plurality of first holes each is aligned and communicated with one of the plurality of forth holes; and
the method further comprises:
thinning the fourth substrate from an upper surface of the fourth substrate to form a new upper surface to expose the plurality of fourth holes;
filling a conductive metal in the plurality of fourth holes and corresponding holes aligned and communicated with the plurality of fourth holes to form conductive through holes; and
forming conductive pads on the upper surface of the fourth substrate, each of the conductive pads being electrically connected to one of the conductive through holes.

27. The method according to any one of claims 22 to 26, wherein in the forming the protrusion structures, each of the protrusion structure is formed by etching one of the substrate.

28. An electronic apparatus, comprising the semiconductor structure according to any one of claims 1 to 21 or a semiconductor structure manufactured by the method according to any one of claims 22 to 27.
